Europäisches Patentamt

European Patent Office

Office européen des brevets

(11) Veröffentlichungsnummer: **0 096 766**
**B1**

# EUROPÄISCHE PATENTSCHRIFT

(45) Veröffentlichungstag der Patentschrift: **23.03.88**

(51) Int. Cl.⁴: **G 03 F 7/26**

(21) Anmeldenummer: **83105072.9**

(22) Anmeldetag: **21.05.83**

(54) Vorrichtung zum Behandeln von nach photochemischen Verfahren hergestellten flexiblen Druckplatten.

(30) Priorität: **03.06.82 DE 3220902**

(43) Veröffentlichungstag der Anmeldung:
**28.12.83 Patentblatt 83/52**

(45) Bekanntmachung des Hinweises auf die
Patenterteilung:
**23.03.88 Patentblatt 88/12**

(84) Benannte Vertragsstaaten:
**AT BE CH DE FR GB IT LI NL**

(56) Entgegenhaltungen:
BE-A- 828 282
US-A-3 552 293

PATENTS ABSTRACTS OF JAPAN, Band 5, Nr.
185, November 25, 1981, Seite (P91) 857r

(73) Patentinhaber: **BASF Aktiengesellschaft
Carl-Bosch-Strasse 38
D-6700 Ludwigshafen (DE)**

(72) Erfinder: **Buerger, Arnulf, Dr.
Weimarer Strasse 8
D-6700 Ludwigshafen (DE)**
Erfinder: **Scharff, Karl-Heinz
Londoner Ring 15
D-6700 Ludwigshafen (DE)**
Erfinder: **Geiger, Kurt
Von-Stephan-Strasse 50
D-6700 Ludwigshafen (DE)**
Erfinder: **Schnee, Guenther
Bruesseler Ring 44
D-6700 Ludwigshafen (DE)**
Erfinder: **Pieper, Hartwig
Osloer Weg 8
D-6700 Ludwigshafen (DE)**

**Beschreibung**

Die Erfindung betrifft eine Vorrichtung zum Behandeln von nach photochemischen Verfahren hergestellten flexiblen Druckplatten, insbesondere von aus photopolymerisierbaren Stoffen hergestellten und mit aktinischem Licht bestrahlten Druckplatten, die in einem geschlossenen Gehäuse mittels rotierender mit Waschflüssigkeit beaufschlagter Bürsten und Walzen ausgewaschen und gereinigt werden, und mittels eines zwischen den Walzen angeordneten Tisches und mittels der Walzen transportiert werden, wobei die ersten drei Walzenpaare die Funktion des Transports und die beiden folgenden Walzenpaare zusätzlich zum Transport die Funktion der Reinigung und teilweisen Trocknung ausüben.

Flexible, nach photochemischen Verfahren hergestellte Druckplatten werden hauptsächlich im Verpackungs- und Endformulardruck verwendet.

Es ist bekannt, nach dem bildmäßigen Belichten der Druckplatten, diese mittels einer Auswaschlösung auszuwaschen, d.h. das Material der unbelichteten Bildbereiche der Druckplatten wird während des Auswaschvorganges mit Auswaschlösung entfernt. Hierzu werden verschiedenartigste Vorrichtungen verwendet, beispielsweise eine Vorrichtung bestehend aus einer in einem geschlossenen Gehäuse gelagerten rotierenden Trommel — auf die die flexible Druckplatte aufgespannt is — und mehreren, am Umfang der Trommel angeordneten gleich- und gegenläufig zu der Trommel rotierenden, mit Auswaschlösung besprühten Bürstenwalzen. Mittels dieser Bürstenwalzen und der Auswaschlösung wird das oben erwähnte Material von den belichteten Druckplatten entfernt.

Diese derzeit für flexible Druckplatten hauptsächlich verwendete Vorrichtung hat jedoch verschiedene Nachteile, beispielsweise muß zum Aufspannen der Druckplatte auf die Trommel und zum Abnehmen der Druckplatte von der Trommel das Gehäuse jeweils geöffnet werden, wobei die Bedienungsperson trotz aufwendiger Absaugeinrichtungen mit den Lösungsmitteldämpfen der Auswaschlösung in Berührung kommt, und die Einhaltung der MAK-Werte (maximale Arbeitsplatzkonzentration) nicht immer — je nach Qualität der Absaugeeinrichtungen — gewährleistet ist. Des weiteren ist die Bedienungsperson gezwungen, nach dem Auswaschen die nassen Druckplatten manuell von der Trommel zu entfernen und in ein Trocknungsgerät einzulegen. Ein weiterer Nachteil ist zudem, daß in einem bestimmten Auswaschgerät nur Druckplatten behandelt werden können, die durch das Auswaschgerät vorgegebene Längen und Breiten nicht überschreiten dürfen. Außerdem erfordern die bekannten Vorrichtung lange Auswaschzeiten, d.h. die Auswaschkontaktzeit zwischen Auswaschlösung und auszuwaschender Druckplatte ist extrem lang, was einerseits die Auswaschkapazität deutlich verringert und andererseits zur Deformierung oder gar Zerstörung feiner Reliefteile auf der belichteten Druckplatte führt, was wiederum die Qualität der Drucke beeinträchtigt.

Des weiteren sind in verwandten Gebieten der Reproduktionstechnik Vorrichtungen für Druckplatten — die nach dem Belichten nur geringfügig kleben, geringe Relieftiefen und hohe Stabilität aufweisen — bekannt, mit denen die oben erwähnten Nachteile vermieden werden.

Der Erfindung liegt daher die Aufgabe zugrunde, dieselben bekannten Vorrichtungen auch für flexible Druckplatten, die gleichzeitig nach dem Belichten stark kleben und hohe Relieftiefen aufweisen, einzusetzen, um dadurch die oben erwähnten Nachteile zu beseitigen. Hierzu war es jedoch notwendig das Transportproblem der flexiblen Druckplatten innerhalb der Vorrichtung zu beheben, da die flexiblen Druckplatten auf glatten Walzen nicht weitertransportiert werden konnten.

Diese Aufgabe wird erfindungsgemäß durch eine Vorrichtung gelöst, bei der die oberen Walzen der drei Transportwalzenpaare und die obere Walze des den Transportwalzenpaaren folgenden Reinigungswalzenpaares mit Velour überzogen sind, die dazugehörigen unteren Walzen der vorgenannten Walzenpaare und die obere Walze und die untere Walze des zweiten Reinigungswalzenpaares mit einem Textilgewebe überzogen sind, und an den oberen Walzen des ersten und zweiten Transportwalzenpaares parallel zu den Walzenachsen verlaufende Abstreiflineale mit Niederhaltern und an den oberen Walzen des dritten Transportwalzenpaares und der Reinigungswalzenpaare parallel zu den Walzenachsen verlaufende Abstreiflineale angeordnet sind.

Weitere Merkmale der erfindungsgemäßen Vorrichtung sind Gegenstand der Unteransprüche.

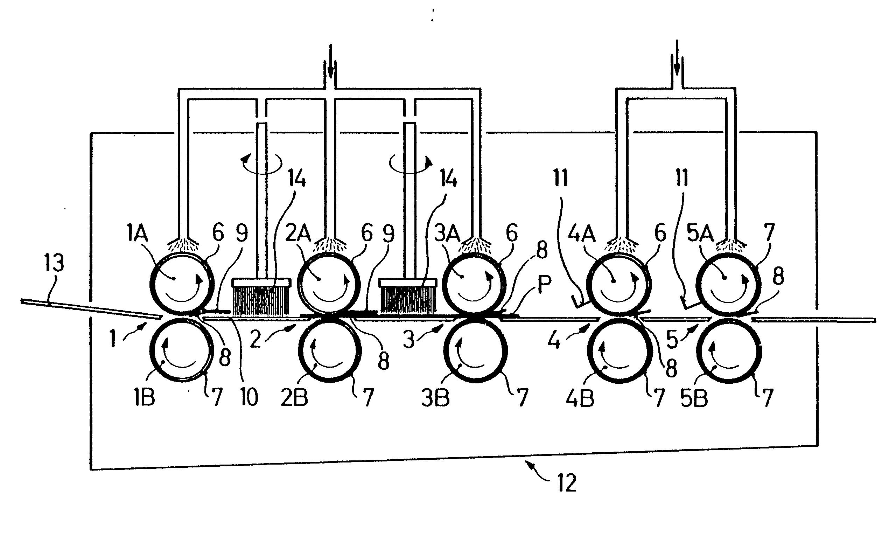

Ein Ausführungsbeispiel der Erfindung ist in der Zeichnung dargestellt und wird im folgenden näher beschrieben. Die Zeichnung zeigt einen Schnitt durch die erfindungsgemäße Vorrichtung.

In einem geschlossenen Gehäuse 12 sind in gleichem Abstand drei Transportwalzenpaare 1, 2, 3 und zwei Reinigungswalzenpaare 4, 5 hintereinander angeordnet. Zwischen den fünf Walzenpaaren befindet sich ein waagrechter, ebener Tisch 10 und vor dem ersten Transportwalzenpaar 1 — außerhalb des geschlossenen Gehäuses 12 — befindet sich ein geneigter Auflegetisch 13. Zwischen den Walzenpaaren 1—2 und 2—3 sind jeweils mehrere, senkrecht zur belichteten Druckplatte gerichtete rotierende, gegenläufig drehende Bürsten 14 angeordnet, denen zentral Auswaschlösung zugeführt wird. Über allen fünf Walzenpaaren ist jeweils eine Besprühvorrichtung mit Auswaschlösung für die Walzenpaare angebracht. Die Walzen 1A, 2A, 3A und 4A sind mit Velour 6, die Walzen 5A, 1B, 2B, 3B, 4B und 5B mit Textilgewebe überzogen.

Die Walzen 1A und 2A sind mit Abstreiflinealen 8 und Niederhaltern 9, die Walzen 3A, 4A und 5A nur mit Abstreiflinealen 8 ausgerüstet. Die Abstreiflineale 9 sind schleifend an den Walzen angeordnet. An den Walzen 4A und 5A sind außerdem Rakelmesser 11 auf der gesamten Breite der Walzen angebracht. Hinter dem Reinigungswalzenpaar 5 befindet sich die direkt mit dem geschlossenen Gehäuse 12 zusammengebaute Trocknungseinheit.

Erläuternd zum Aufbau der erfindungsgemäßen Vorrichtung wird der Verfahrensablauf des Auswaschens, Reinigens und teilweisen Trocknens der belichteten Druckplatten erläutert. Die belichtete Druckplatte wird über den geneigten Auflagetisch dem geschlossenen Gehäuse und dem ersten Transportwalzenpaar zugeführt. Anschließend erfolgt ein kontinuierlicher Transport der belichteten Druckplatte durch das geschlossene Gehäuse mittels der fünf Walzenpaare und eine kontinuierliche Übergabe der ausgewaschenen, gereinigten und teilweise getrockneten Druckplatte in die Trocknungseinheit. Das Auswaschen des unbelichteten Materials erreicht man mittels der Bürsten und der Auswaschlösung, die sowohl zentral den Bürsten zugeführt wird, als auch auf die Transportwalzenpaare aufgesprüht wird. Die schleifend angeordneten Abstreiflineale bewirken, daß die Druckplatten nicht an den Walzen festkleben, sondern auf dem Tisch weiter gleiten, die Niederhalter wiederum bewirken, daß die Druckplatten nicht von dem Tisch abheben. Die Reinigung der Druckplatten nach dem Auswaschen erfolgt mittels der mit Auswaschlösung besprühten Reinigungswalzen, wobei durch die Rakelmesser ein Teil der Waschflüssigkeit abgerakelt wird, was wiederum den Velour bzw. den Textilgewebeüberzug saugfähig macht, wodurch eine Teiltrocknung der belichteten, ausgewaschenen und gereinigten Druckplatten erreicht wird. Die Auswaschlösung für die Bürsten und die Transportwalzen wird bis zu einer gewissen Sättigung mit Material im Kreis gefahren, für die Reinigungswalzen wird frische Auswaschlösung verwendet.

Die mit der Erfindung erzielten Vorteile bestehen insbesondere darin, daß zum Einlegen und Entfernen der Druckplatte ein Öffnen des Gehäuses entfällt, wodurch die MAK-Werte eingehalten werden können, daß das manuelle Herausnehmen der nassen Druckplatten aus dem Gehäuse durch die Bedienungsperson entfällt, daß die Länge der Druckplatten keinerlei Beschränkung unterliegt und daß die Auswaschzeiten deutlich verringert werden, was wiederum aus den oben erwähnten Gründen zu einer besseren Qualität der Drucke führt.

**Patentansprüche**

1. Vorrichtung zum Behandeln von nach photochemischen Verfahren hergestellten flexiblen Druckplatten, insbesondere von aus photopolymerisierbaren Stoffen hergestellten und mit aktinischem Licht bestrahlten Druckplatten, die in einem geschlossenen Gefäß mittels rotierender mit Waschflüssigkeit beaufschlagter Bürsten ausgewaschen und gereinigt werden, und mittels eines zwischen den Walzen angeordneten Tisches und mittels der Walzen transportiert werden, wobei die ersten drei Walzenpaare die Funktion des Transports und die beiden folgenden Walzenpaare zusätzlich zum Transport die Funktion der Reinigung und teilweisen Trocknung ausüben, dadurch gekennzeichnet, daß die oberen Walzen (1A, 2A, 3A) der drei Transportwalzenpaare (1, 2, 3) und die obere Walze (4A) des den Transportwalzenpaaren folgenden Reinigungswalzenpaares (4) mit Velour (6) überzogen sind, die dazugehörigen unteren Walzen (1B, 2B, 3B, 4B) der vorgenannten Walzenpaare (1, 2, 3, 4) und die obere Walze (5A) und die untere Walze (5B) des zweiten Reinigungswalzenpaares (5) mit einem Textilgewebe (7) überzogen sind, und an den oberen Walzen der Transportwalzenpaare (1, 2) parallel zu den Walzenachsen verlaufende Abstreiflineale (8) mit Niederhaltern (9) und an den oberen Walzen des Transportwalzenpaares (3) und der Reinigungswalzenpaare (4, 5) Abstreiflineale (8) angeordnet sind.

2. Vorrichtung nach Anspruch 1, dadurch gekennzeichnet, daß die Abstreiflineale (8) mit Niederhaltern (9) im Abstand der Druckplattenstärke über dem zwischen den Walzen angeordneten Tisch (10) schleifend an der Walzenoberfläche angeordnet sind.

3. Vorrichtung nach den Ansprüchen 1 und 2 dadurch gekennzeichnet, daß die abstreiflineale (8) mit den oder ohne den Niederhaltern (9) mit den Walzen fest verbunden sind.

4. Vorrichtung nach den Ansprüch 1 bis 3, dadurch gekennzeichnet, daß die Reinigungswalzenpaare (4, 5) mit Rakelmessern (11) ausgerüstet sind.

**Revendications**

1. Installation pour le traitement de plaques d'impression flexibles, obtenues par un procédé photochimique, en particulier de plaques d'impression produites à partir de matières photopolymérisables et exposées à de la lumière actinique, qui sont lavées et nettoyées dans une cuve fermée à l'aide de brosses rotatives, alimentées en liquide de lavage, (et de rouleaux) et acheminées sur un plateau disposé entre les rouleaux par les rouleaux, dont les trois premières paires de rouleaux assurent l'acheminement et les deux paires suivantes assurent le transport et le nettoyage et un séchage partiel, caractérisée en ce que les rouleaux supérieurs (1A, 2A, 3A) des trois paires de rouleaux de transport (1, 2, 3) et le rouleau supérieur (4A) de la paire de rouleaux de nettoyage (4), disposée à la suite des paires de rouleaux de transport, sont garnis de velours (6), tandis que les rouleaux inférieurs (1B, 2B, 3B, 4B) correspondants des paires de rouleaux (1, 2, 3, 4), ainsi que le rouleau supérieur (5A) et le rouleau inférieur (5B) de la deuxième paire de rouleaux de nettoyage (5) sont garnis d'un tissu textile (7), les rouleaux supérieurs des paires de rouleaux de transport (1, 2) étant munis de racles détacheuses (8) parallèles aux axes des rouleaux et d'organes de serrage (9) et les rouleaux supérieur de la paire de rouleaux de transport (3) et des paires de rouleaux de nettoyage (4, 5) de racles détacheuses (8).

2. Installation suivant la revendication 1, caractérisée en ce que les racles détacheuses (8) avec les dispositifs de serrage (9) sont disposés à une distance de la table (10), disposée entre les rouleaux, correspondant à l'épaisseur des plaques d'impression, et en contact à frottement avec la surface du rouleau correspondant.

3. Installation suivant les revendications 1 et 2, caractérisée en ce que les racles détacheuses (8) avec ou sans dispositif de serrage (9) sont fixées aux rouleaux.

4. Installation suivant les revendications 1 à 3, caractérisée en ce que les paires de rouleaux de nettoyage (4, 5) sont équipées de couteaux racleurs (11).

**Claims**

1. Apparatus for treating flexible printing plates produced by a photochemical method, in particular those produced from photopolymerizable substances which are exposed to actinic light and washed out and cleaned in a closed housing by means of rotating brushes on which washout liquid impinges and are transported by means of a table located between the rollers and by means of the rollers, and the first three pairs of rollers effect transport while the two subsequent pairs of rollers effect cleaning and partial drying in addition to transport, wherein the upper rollers (1A, 2A, 3A) of the three pairs of transport rollers (1, 2, 3) and the upper roller (4A) of the pair of cleaning rollers (4) downstream from the pairs of transport rollers are covered with velour (6), the corresponding lower rollers (1B, 2B, 3B, 4B) of the abovementioned pairs of rollers (1, 2, 3, 4) and the upper roller (5A) and the lower roller (5B) of the second pair of cleaning rollers (5) are covered with a textile fabric (7), and scrapers (8) having hold-down plates (9) are located, parallel to the roller axes, at the upper rollers of the pairs of transport rollers (1, 2), and scrapers (8) are located at the upper rollers of the pair of transport rollers (3) and of the pair of cleaning rollers (4, 5).

2. Apparatus as claimed in claim 1, wherein the scrapers (8) provided with hold-down plates (9) are mounted above the table (10) located between the rollers, the scrapers being positioned so as to scrape the surface of the roller, and the distance from the table to the scraper corresponding to the thickness of the printing plate.

3. Apparatus as claimed in claims 1 and 2, wherein the scrapers (8) with or without the hold-down plates (9) are firmly attached to the rollers.

4. Apparatus as claimed in claim 1 or 2 or 3, wherein the pairs of cleaning rollers (4, 5) are provided with doctor blades (11).